# EUROPEAN PATENT APPLICATION

(11) **EP 2 120 271 A1**
(43) Date of publication of application: **18.11.2009**
(21) Application number: 08712133.1
(22) Date of filing: 29.02.2008
(51) Int. Cl.: H01L 33/00

(54) **LED DEVICE AND ILLUMINATING APPARATUS**

(30) Priority: 01.03.2007 JP 2007051378; 21.02.2008 JP 2008039916
(71) Applicant: NEC Lighting, Ltd., Shinagawa-ku Tokyo 141-0032 (JP)
(72) Inventor: UEJI, Yoshinori, Tokyo 141-0032 (JP)
(74) Representative: Vossius & Partner
(86) International application number: PCT/JP2008/053611
(87) International publication number: WO 2008/105527

(57) **Abstract**

White LED device 20 includes LED chip 13 mounted on substrate 1 made of metal, sealing resin 11 that seals LED chip 13; and glass member 12 formed on sealing resin 11. Glass member 12 contains phosphor 22 and thermal conductivity of sealing resin 11 is lower than that of glass member 12.

## Description

### Technical Field

The present invention relates to a light emitting diode (LED)-equipped LED device and an illuminating apparatus.

### Background Art

As an LED illuminating device that illuminates a display device performing color display using RGB color filters in relation to the present invention, a multi-color mixed type LED illuminating device is in use. The multi-color mixed type LED illuminating device illuminates white light by simultaneously making three RGB color LEDs emit light and performs color display with the white light and the color filters of the display device. However, the multi-color mixed type LED illuminating device has a problem in that each LED of the RGB colors emits light, a large number of LEDs are required to obtain the white light, thereby increasing the cost.

As a solution to the problem of the multi-color mixed type LED illuminating device, for example, a phosphor color mixed type LED illuminating device is disclose in Japanese Patent Publication No. 2998696 and Japanese Laid Open Publication No. JP11-87784. In these documents, phosphor is mixedly included in a resin that seals an LED chip.

### Disclosure of Invention

However, the LED illuminating device having the phosphor contained in the resin has the following problems.
1. Because the resin absorbs moisture, the phosphor absorbs moisture or is oxidized and thereby degraded. Thus, since the phosphor is degraded for a long time, the luminous efficiency of the device deteriorates.
2. Because a light emission wavelength of the phosphor is altered due to heat generated from the LED chip, the required light emission color is changed.

Thus, an object of the present invention is to provide an LED device and an illuminating apparatus capable of preventing a diminution in luminous efficiency and obtaining a predetermined light emission color.

In order to solve the above problems, there is provided an LED device including: an LED chip mounted on a substrate made of metal; a sealing resin that seals the LED chip; and a glass member formed on the sealing resin or encapsulated at a position within the sealing resin where light, which is emitted from the LED chip and which is outputted to the exterior of the device body, passes through, wherein the glass member contains phosphor and a thermal conductivity of the sealing resin is lower than that of the glass member.

Because the LED device according to the present invention as described above contains the phosphor in the glass member, degradation of the phosphor due to moisture absorption or oxidation can be prevented. In addition, because the glass member is disposed with the sealing resin having thermal resistance, degradation of the phosphor can be lessened, and accordingly, diminution in the luminous efficiency can be prevented. Also, because heat generated by the LED chip is released from the metal substrate, a change in the light emission wavelength of the phosphor can be prevented, and thus, a predetermined light emission color can be obtained.

In particular, in the case of the configuration in which the glass member is encapsulated in the sealing resin, there is no air layer formed between the glass member and the sealing resin. Thus, light which has passed through the sealing resin after being outputted from the LED chip can be prevented from being totally reflected to be attenuated and die out in the sealing resin before it enters the air layer.

The light emission wavelength of the LED chip of the LED device may range from 250 nm to 500 nm.

The glass member of the LED device may have a sectional shape according to light distribution characteristics of the LED chip. In this case, a uniform light emission color may be obtained.

The glass member of the LED device may have a plurality of glass layers, and each glass layer may contain at least one color of phosphor. If a plurality of colors of phosphor are in use, phosphor of light may be separately contained in each of the plurality of glass layers to prevent an occurrence of phosphor distribution deficiency or bias.

The glass member of the LED device may be sandwiched by protection members. With such a configuration, the glass member can be prevented from being damaged by an external force or by a stress due to the difference between the coefficient of thermal expansion of the glass member and that of the sealing resin.

The protection members may be made of a material harder than the glass member, or may be made of a material softer than the glass member.

The sealing resin of the LED may contain a diffuser, and in this case, the diffuser may cause light distribution of the LED chip to become uniform.

The LED chip and the substrate of the LED device may be bonded by soldering or bonded by an adhesive material with a thermal conductivity higher than that of soldering. In this case, heat generated from the LED chip can be easily thermally conducted to the substrate, improving the heat release characteristics, which results in preventing a change in the light emission wavelength of phosphor to thus obtain a predetermined light emission color.

The substrate of the LED device may include a connector for an electrical connection with the exterior. In this case, if the LED chip is a power LED and has a high heat capacity, which, thus, can be firmly mounted through soldering, the LED chip can be easily mounted on a different electronic devices and the like.

In the LED device, feeding power to the LED chip can be made through a lead frame.

The illuminating apparatus includes the LED device according to the embodiments of the present invention.

According to the present invention, because the phosphor is contained in the glass member, degradation of the phosphor due to moisture absorption or oxidation can be prevented. In addition, heat generated from the LED chip is released from the metal substrate and the glass member is disposed by the medium of the heat-resistant sealing resin having thermal resistance, degradation of the phosphor due to heat can thus be prevented. As a result, a diminution in the luminous efficiency of the LED device can be prevented and a predetermined light emission color can be obtained.

### Brief Description of the Drawings

[FIG. 1] is a side-sectional view of a white LED device according to a first exemplary embodiment of the invention;

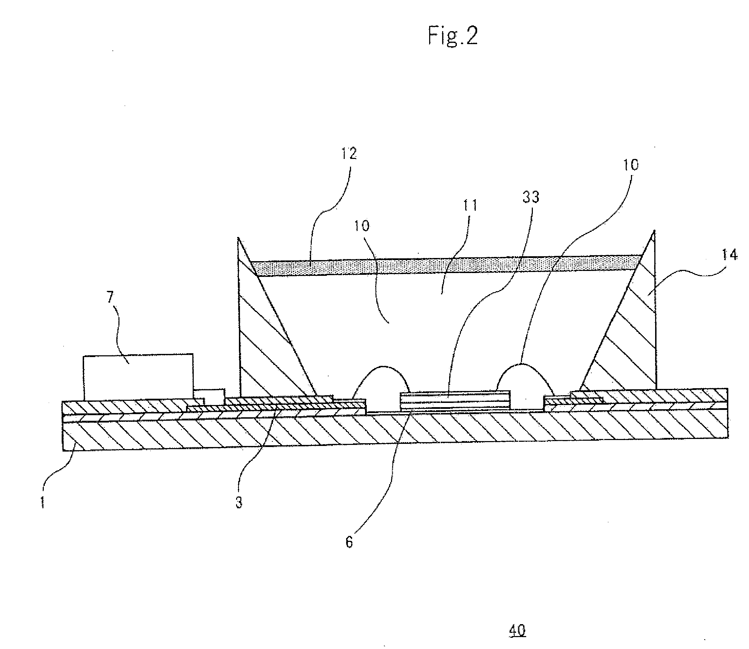

[FiG. 2] is a side sectional view of a white LED device according to a second exemplary embodiment of the invention;
[FIG. 3] is a schematic view showing an example of the shape of a glass member;
[FIG. 4] is a schematic view showing another example of the shape of the glass member;
[FIG. 5] is a side-sectional view showing the configuration of a white LED including a glass member of a laminated structure;
[FIG. 6] is a side-sectional view of a white LED device having a configuration of a white LED including a sealing resin containing a diffuser;
[FIG. 7] is a side-sectional view showing the configuration of a white LED including a glass member sandwiched by protection members;
[FIG. 8] is a side-sectional view of a white LED device including a glass member sandwiched by the protection members and encapsulated within the sealing resin;
[FIG. 9] is a side-sectional view of a white LED device having a power feed structure by a lead frame;
[FIG. 10A] is a side-sectional view of an illuminating apparatus according to an exemplary embodiment of the present invention; and
[FIG. 10B] is a plan view of the illuminating apparatus according to an exemplary embodiment of the present invention.

### Best Mode for Carrying Out the Invention

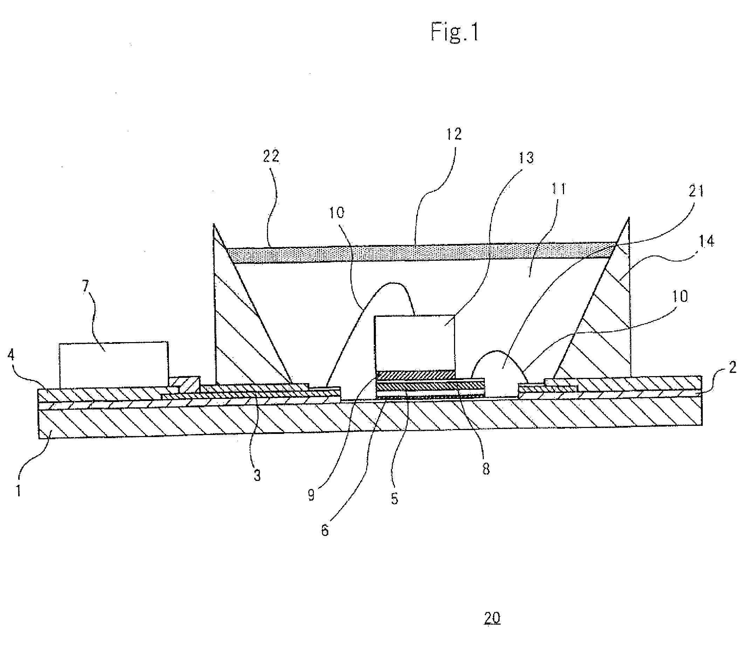

FIG. 1 is a side-sectional view of a white LED device 20 according to a first exemplary embodiment of the invention;

The white LED device 20 according to the first embodiment of the present invention excites phosphor with a gallium nitride (GaN)-based LED (i.e., blue or near-ultraviolet LED) having a light emission wavelength ranging from 250 nm to 500 nm to mix green, red or yellow light emission with blue color to produce white color.

The white LED device 20 includes an LED chip 13 mounted by the medium of a sub-mount 5 on a metal substrate 1. LED chip 13 is sealed with sealing resin 11. Glass member 12 containing phosphor 22 is disposed on sealing resin 11. The white LED device 20 will now be described in detail.

An insulating layer 2 is stacked on metal substrate 1, and wiring layer 3 is stacked on insulating layer 2. Metal substrate 1 is made of metal having high thermal conductivity such as copper (Cu) or aluminum (Al), and an Ni layer and an Au layer are stacked on a mounting surface of sub-mount 5. Insulating layer 2 is made of an insulation resin such as glass epoxy. Wiring layer 3 is made of copper (Cu), and an Ni layer and an Au layer are stacked on an exposed surface of wiring layer 3. Insulation-resist layer 4 made of an epoxy resin is stacked on insulating layer 2. Connector 7 that allows an electrical connection to the exterior is provided on insulation-resist layer 4.

A window unit 21 is formed at insulating layer 2 and wiring layer 3. LED chip 13 mounted on sub-mount 5 is disposed within window unit 21. LED chip 13 and sub-mount 5 are bonded by hard solder 9. Metal substrate 1 and sub-mount 5 are bonded by soft solder 6 having a lower melting point than that of hard solder 9. For example, hard solder 9 is made of AuSn, the soft solder is made of SnAgCu, and sub-mount 5 is made of AIN. LED chip 13 has an InGaN-based light emission layer on the Al₂O₃ or SiC substrate. LED chip 13 is formed as a blue or near-ultraviolet chip with a light emission wavelength ranging from 250 nm to 500 nm. A rear surface of LED chip 13 is coated by Au.

LED chip 13 is electrically connected with wiring layer 3 formed on insulating layer 2 by electrical connection wiring 10 made of Au. Wiring layer 8 is formed on sub-mount 5 and is electrically connected with wiring layer 3 by electrical connection wiring 10.

LED chip 13, sub-mount 5, and the respective electrical connection wirings 10 are disposed within reflector 14 made of an Al-based metal. Sealing resin 11, a silicon-based transparent resin, is charged within reflector 14 to resin-seal LED chip 13, sub-mount 5, and the respective electrical connection wirings 10. As sealing resin 11, a resin with a thermal conductivity lower than that of the at least glass member 12 is used. This is to allow sealing resin 11 to have a thermal resistance, making it difficult for heat generated from LED chip 13 to be conducted to glass member 12.

Glass member 12 containing phosphor 22, the feature of the present invention, is disposed on the surface of sealing resin 11. Light from LED chip 13 and light reflected from reflector 14 pass through glass member 12 so as to be outputted to the exterior.

Glass member 12 contains the following type of phosphor 22 within glass.
1. Eu-activated aluminum silicon nitride-based nitride phosphor (red) having Sc-based Ce-activated oxide phosphor (green)
2. Eu-activated oxide phosphor (green ∼ yellow) and Eu-activated aluminum silicon nitride-based nitride phosphor (red)
3. Eu-activated thiogallate-based sulfides phosphor (green - yellow) and Eu-activated alkali-based sulfides phosphor (orange - red)
4. Eu-activated silicate-based oxide phosphor (green ∼ yellow) and Eu-activated alkali-based sulfides phosphor (orange ∼ red)
The above combinations are merely typical combinations and the present invention is not meant to be limited thereto.

By using the fact that the refraction index of sealing resin 11 is smaller than that of glass member 12, light outputted from LED chip 13 can be effectively used as excitation light, without being reflected from glass member 12. For example, if the reflection index of glass member 12 is 1.5, that of sealing resin 11 may be about 1.4.

In the present exemplary embodiment, because phosphor 22 is encapsulated within glass member 12, it can be prevented from absorbing moisture or being oxidized that will result in degradation. In addition, sealing resin 11 serving as heat resistance exists between LED chip 13, a heating member, and phosphor 22. Also, heat generated from LED chip 13 is largely conducted sequentially to hard solder 9, sub-mount 5, soft solder 6, and metal substrate 1 via the Au film formed on the rear surface of LED chip 13, and is finally released from the rear surface of metal substrate 1. Accordingly, degradation of phosphor 22 caused by the heat from LED chip 13 can be lessened and a change in the light emission wavelength of phosphor 22 can be prevented, resulting in obtaining a predetermined light emission color by the white LED device 20.

As described above, by encapsulating phosphor 22 in glass member 12, degradation of phosphor 22 that otherwise results from moisture absorption, oxidation, and heat can be prevented, and accordingly, a change in the light emission wavelength of phosphor 22 can be prevented.

In addition, the white LED device according to the present exemplary embodiment 20 has connector 7 for an external connection. In case of a high power LED, because it has a high thermal capacity, its mounting through soldering is difficult. However, because the white LED 20 has connector 7, the white LED device 20 can be easily mounted on a different electronic device, without the necessity of being mounted through soldering.

Also, in the present exemplary embodiment, the case where only one LED chip 13 is mounted is illustrated, but the present invention is not meant to be limited thereto and two or more LED chips 13 may be mounted. In the white LED device 20 according to the present exemplary embodiment, phosphor 22 is encapsulated in glass member 12 and heat is satisfactorily released from metal substrate 1. Thus, even if two or more LED chips 13 are mounted to increase the amount of light as a single device and thus the heating value is increased, the white LED device 20 whose luminous efficiency is prevented from degradation can be advantageously used and a predetermined light emission color can be obtained by the white LED device 20.

### [Second embodiment]

LED chip 33 of white LED device 40 according to this embodiment uses a configuration in which a P pole and an N pole are provided on its upper surface, and is mounted on metal substrate 1 without using a sub-mount therebetween. Other basic configuration is the same as that of the first embodiment, so its detailed description will be omitted.

A plated layer (e.g., a gold-plated layer) is formed on a lower surface of LED chip 33 where the P pole and the N pole are not formed, so as to be adapted to soldering. The lower surface of LED chip 33 faces to be bonded with metal substrate 1 by soft solder 6. The P pole and the N pole are electrically connected to the wiring layers 3 by the electrical connection wirings 10. Namely, in the present exemplary embodiment, as described above, the P pole and the N pole are formed on the upper surface of LED chip 33 and are not formed on the lower surface of LED chip 33, so insulation by a sub-mount is not necessary. Also, a hard solder for bonding the sub-mount is not required. Namely, in the present exemplary embodiment, heat resistance from LED chip 33 to metal substrate 1 is diminished, heat releasing is accelerated to effectively reduce degradation by heat generated from phosphor 22. In addition, because a change in the light emission wavelength of phosphor 22 is prevented, a predetermined light emission color can be obtained by the white LED 40.

Further, because LED chip 33 according to the present exemplary embodiment does not require a sub-mount or a hard solder, the fabrication process can be simplified and the number of components of the device can be reduced.

Moreover, in the present exemplary embodiment, because the electrical connection wirings 10 do not need to be drawn out of a sub-mount, the mounting area may be equal to the area corresponding to the LED chip, and accordingly, the device can be reduced in size.

### (Other embodiments)

### [Glass member in a lens shape]

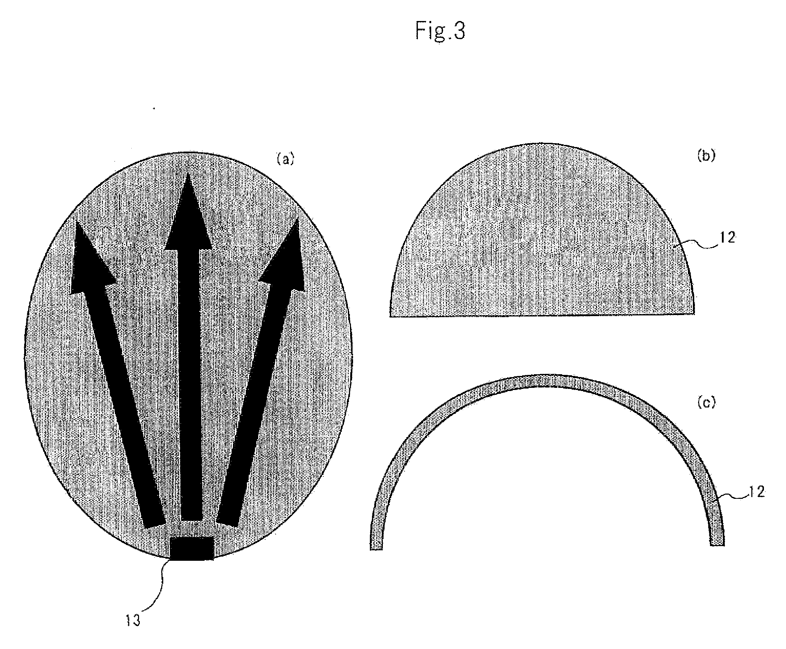

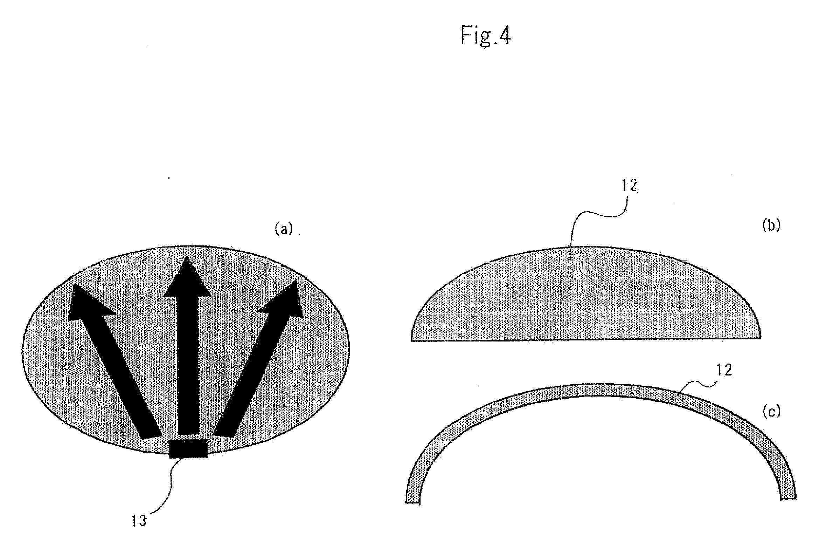

Glass member 12 according to an exemplary embodiment of the present invention may have a shape based on light distribution characteristics of the LED chip as shown in FIGs. 3 and 4.

As shown in FIG. 3(a), when the light distribution characteristics of LED chip 13 is concentrated to a front side, glass member 12 may have a lens shape with its central portion convex as shown in FIGs. 3(a) and 3(b). Meanwhile, FIG. 3(a) illustrates glass member 12 in the shape of a solid-core hemisphere, and FIG. 3(b) illustrates glass member 12 in the shape of a hallow hemisphere.

If the light distribution characteristics of LED chip 13 shows diffused light distribution as shown in FIG. 4(a), glass member 12 may have the shape of a flat lens as shown in FIGs. 4(a) and 4(b). Meanwhile, FIG. 4(a) illustrates glass member 12 in the shape of a solid-core hemisphere, and FIG. 4(b) illustrates glass member 12 in the shape of a hallow hemisphere.

In this manner, a uniform light emission color can be obtained by shaping glass member 12 according to the light distribution characteristics.

### [Glass member in a laminated structure]

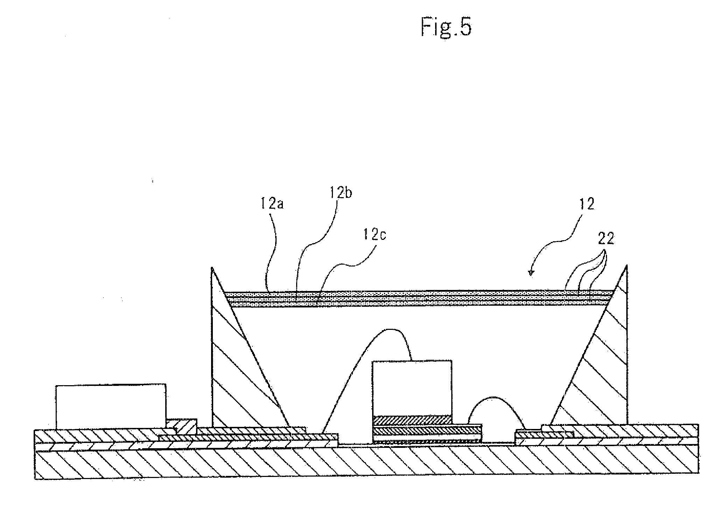

As shown in FIG. 5, glass member 12 according to an exemplary embodiment of the present invention may have a laminated structure including a first glass layer 12a, second glass layer 12b, and third glass layer 12c. In this case, each of glass layers 12a to 12c may contain a unicolor phosphor 22. With such configuration, distribution deficiency or deflection of phosphor 22 in each color may be prevented. Meanwhile, the number of laminated layers is not limited to the three layers. That is, glass member 12 may have a two-layer structure or may have a four or more-layer structure. Also, the phosphor contained in each glass layer is not limited to a single color. For example, if the glass layer has a two-layer structure, one of the layers may be unicolor while the other may have two or more colors. If a four-color phosphor is in use, each layer may contain a two-color phosphor.

Meanwhile, the laminated structure of the glass member is not limited to the laminating of the glass layers in the planar shape as shown in FIG. 5 but the curved glass members as shown in FIGs. 3(b) or 4(b) may be laminated.

### [Sealing resin containing diffuser]

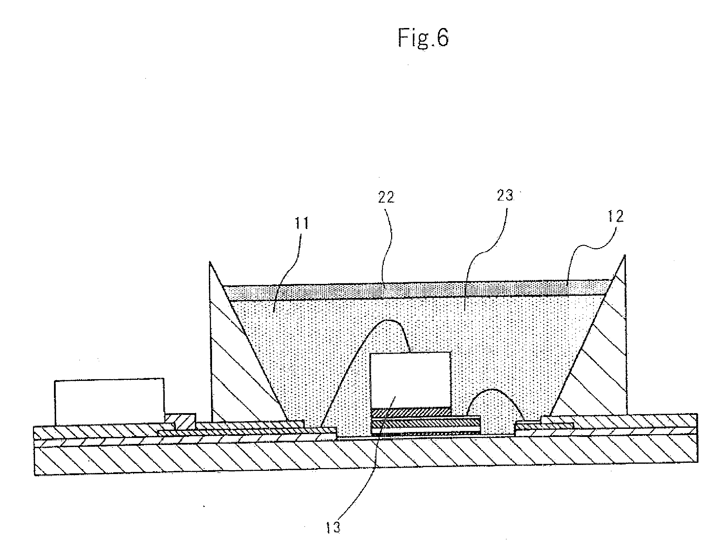

As shown in FIG. 6, sealing resin 11 may contain diffuser 23 made of powder type silica or the like. With diffuser 23 contained in sealing resin 11, the light distribution of LED chip 13 may become uniform.

### [Protection members for protecting glass member, and encapsulating sealing resin by glass member]

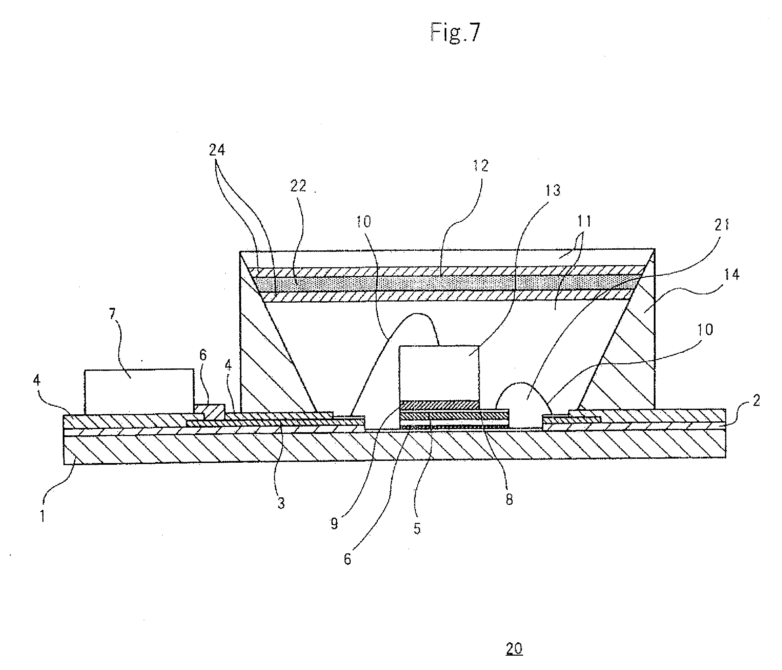

FIG. 7 is a side-sectional view showing the configuration of a white LED including protection members for protecting the glass member.

Glass member 12 contains phosphor 22 therein, so its degree of strength is degraded compared with a glass member that does not contain phosphor 22.

Thus, in order to prevent glass member 12 from being damaged, the white LED device according to an exemplary embodiment of the present invention may be configured to have protection members 24 formed on both sides of glass member 12 as shown in FIG. 7.

Protection members 24 prevent an external force from being directly applied to glass member 12 to thus protect glass member 12 against damage. Protection members 24 may be any member so long as it does not hinder light from being outputted from LED chip 13 as much as possible. For example, as protection members 24, a member such as a metal latticed guide or transparent hard glass having a higher degree of strength than that of glass member 12 may be employed. Because glass member 12 is reinforced by the hard members, it cannot be deformed or damaged.

Meanwhile, conversely, a member, such as transparent gel type silicon or the like, having a higher flexibility than that of glass member 12 may be used as protection members 24. By sandwiching glass member 12 in between the highly flexible members, an external force can be absorbed and thus glass member 12 can be prevented from being damaged.

In the above-described configuration, glass member 12 is disposed on sealing resin 11, but in an exemplary embodiment of the present invention, glass member 12 may be encapsulated within sealing resin 11. With this configuration, an air layer may not be interposed between sealing resin 11 and glass member 12. With the presence of an air layer, light, which has been outputted from LED chip 13 and then passed through sealing resin 11, may be totally reflected before it enters the air layer and finally weaken and dies out within sealing resin 11. Thus, glass member 12 is encapsulated within sealing resin 11 to omit an air layer, and accordingly, light can be inputted to glass member 12 without being attenuated or dying out.

However, the coefficients of linear expansion of glass member 12 and that of sealing resin 11 are different. Thus, stress is bound to be applied to glass member 12 encapsulated in sealing resin 11 by heat generated when LED chip 13 emits light.

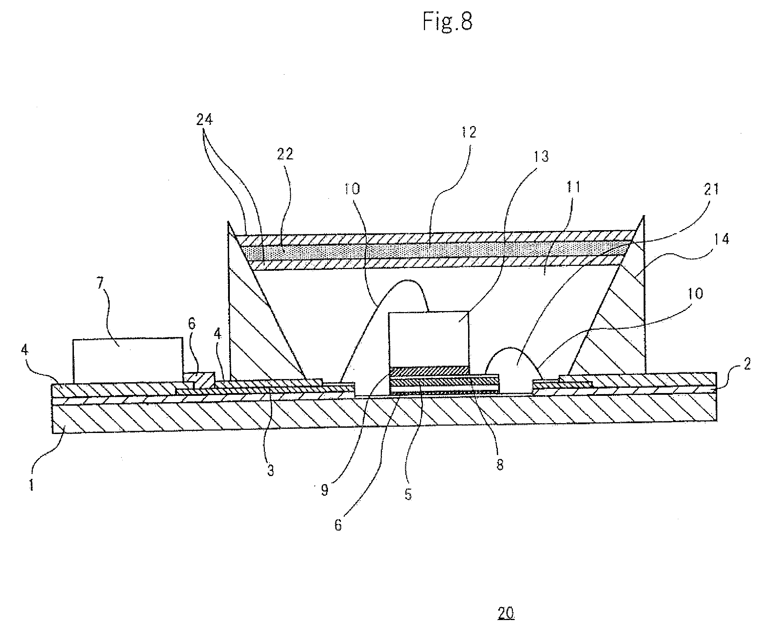

The sandwich structure of glass member 12 sandwiched by protection members 24 can prevent damage of glass member 12 caused by the stress. FIG. 8 is a side-sectional view of a white LED device including a glass member having the protection members and encapsulated within the sealing resin.

Glass member 12 sandwiched by protection members 24 is encapsulated at a position where light outputted from LED chip 13 and light reflected from reflector 14 pass through glass member 12. Namely, light from LED chip 13 and light reflected from reflector 14 pass through glass member 12 and are outputted to the exterior of the main body of white LED device 20.

FIGs. 7 and 8 illustrate protection members 24 provided on both principal surfaces of glass member 12, but the present invention is not meant to be limited thereto. For example, protection members 24 may be coated on every surface of glass member 12 including the sides as well as both principal surfaces.

### [Power feeding structure by lead frame]

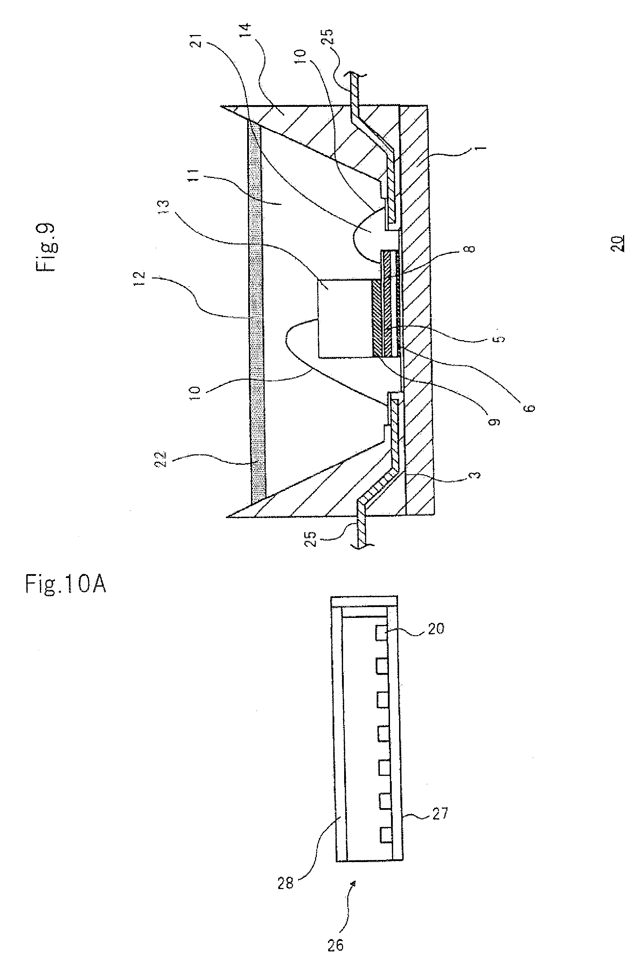

In the above-described configurations, feeding power to LED chip 13 is made via wiring layer 3 formed on insulating layer 2. However, the present invention is not limited thereto. For example, as shown in FIG. 9, feeding power may be made via resin-molded lead frame 25. In FIG. 9, a connector or the like is not illustrated.

Lead frame 25 penetrates reflector 14, of which one end is electrically connected to an external power source (not shown) and the other end is electrically connected to electrical connection wiring 10.

### [Bonding of the LED chip and the metal substrate]

In the first exemplary embodiment, sub-mount 5 with LED chip 13 mounted thereon and metal substrate 1 are bonded by soft solder 6. In the second exemplary embodiment, LED chip 33 and metal substrate 1 are bonded by soft solder 6. However, the bonding of LED chip-mounted sub-mount 5 or LED chip 33 with metal substrate 1 is not limited to the soldering. For example, they may be bonded by using an adhesive material with a higher thermal conductivity than that of the soldering. As the adhesive material, a material that contains more than 90% Ag may be used.

Various embodiments have been described, and in the present invention, the above-described embodiments may be variably combined.

### [Illuminating apparatus]

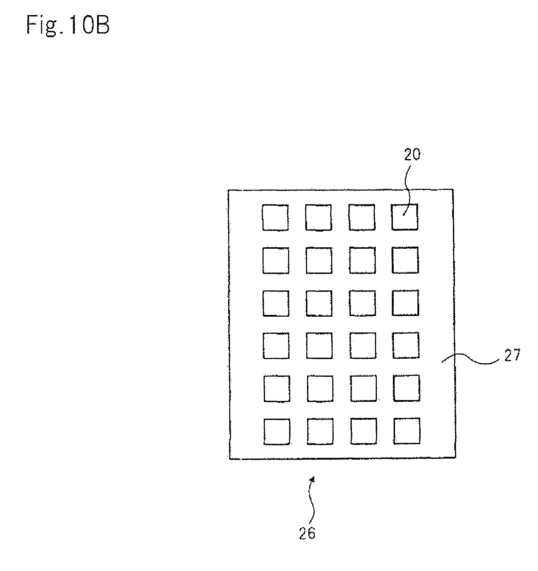

An illuminating apparatus may be configured by using a single or a plurality of white LED devices 20 that emit white light. FIGs. 10A and 10B illustrate exterior perspective views of LED illuminating apparatus according to an exemplary embodiment of the present invention. FIG. 10A is a side-sectional view of the LED illuminating apparatus, and FIG. 10B is a plan view of the LED illuminating apparatus. In FIG. 10B, an accommodating container is omitted.

The LED illuminating apparatus 26 includes a plurality of white LED devices 20 arranged in a matrix form on support substrate 27 and accommodating container 28 that accommodates white LED devices 20.

Meanwhile, FIGs. 10A and 10B illustrate the illuminating apparatus having the plurality of white LED devices 20, but the present invention is not limited thereto and the illuminating apparatus may be configured only with a single white LED device 20.

This application claims priority of Japanese Patent Application Nos. 2007-051378 and 2008-039916 respectively filed on March 1, 2007 and February 21, 2008, the disclosures of which are incorporated herein by reference.

## Claims

1. A LED device comprising:
an LED chip mounted on a substrate made of metal;
a sealing resin that seals the LED chip; and
a glass member formed on the sealing resin or encapsulated at a position within the sealing resin where light, which is emitted from the LED chip and outputted to the exterior of the device body, passes through,
wherein the glass member contains phosphor and thermal conductivity of the sealing resin is lower than that of the glass member.

2. The LED device according to claim 1, wherein a light emission wavelength of the LED chip ranges from 250 nm to 500 nm.

3. The LED device according to claim 1 or 2, wherein the glass member has a sectional shape according to light distribution characteristics of the LED chip.

4. The LED device according to any one of claims 1 to 3, wherein the glass member comprises a plurality of glass layers, and each glass layer contains at least one color of phosphor.

5. The LED device according to any one of claims 1 to 4, wherein the glass member is sandwiched by protection members.

6. The LED device according to claim 5, wherein the protection members are made of a material harder than the glass member.

7. The LED device according to claim 5, wherein the protection members are made of a material softer than the glass member.

8. The LED device according to any one of claims 1 to 7, wherein the sealing resin contains a diffuser.

9. The LED device according to any one of claims 1 to 8, wherein the LED chip and the substrate are bonded by soldering or bonded by an adhesive material having thermal conductivity higher than that of soldering.

10. The LED device according to any one of claims 1 to 9, wherein the substrate comprises a connector for an electrical connection with the exterior.

11. The LED device according to any one of claim 1 to 10, wherein feeding power to the LED chip is made via a lead frame.

12. An illuminating apparatus comprising the LED device recited in any one of claims 1 to 11.
